# EUROPÄISCHE PATENTANMELDUNG

(11) **EP 2 779 447 A1**
(43) Veröffentlichungstag der Anmeldung: **17.09.2014**
(21) Anmeldenummer: 14158908.5
(22) Anmeldetag: 11.03.2014
(51) Int. Cl.: H03H 9/05, H03H 9/10, H01L 41/053, H03H 9/02, H01L 41/313

(54) **Verfahren zur Herstellung eines Sensors und damit hergestellter Sensor**

(30) Priorität: 11.03.2013 AT 500302013
(71) Anmelder: CTR Carinthian Tech Research AG, 9524 Villach/St. Magdalen (AT)
(72) Erfinder: Binder, Alfred, 9523 Landskron (AT); Bardong, Jochen, 9500 Villach (AT); Nicolay, Pascal, 9500 Villach (AT)
(74) Vertreter: Wirnsberger, Gernot

(57) **Zusammenfassung**

Die Erfindung betrifft ein Verfahren zur Herstellung eines Sensors (1) mit zumindest einer Struktur (2), mit der akustische Oberflächenwellen erzeugbar und reflektierbar sind, wobei ein piezoelektrisches Substrat (3) bereitgestellt wird, wonach auf dem Substrat (3) die zumindest eine Struktur (2) angebracht wird, wonach das Substrat (3) mit einem Element (4) verbunden wird. Um dauerhaft bzw. bei Langzeitbetrieb und gegebenenfalls erhöhten Temperaturen eine Dehnung des Substrates (3) am Element (4) zu erreichen, wird erfindungsgemäß zwischen dem Substrat (3) und dem Element (4) ein bei Erwärmung das Substrat (3) und das Element (4) flussmittelfrei selbsttätig verbindendes und zumindest überwiegend metallisches Verbindungsmittel (5) mit einer Schichtdicke von zumindest 10 µm vorgesehen.

## Beschreibung

Die Erfindung betrifft ein Verfahren zur Herstellung eines Sensors mit zumindest einer Struktur, mit der akustische Oberflächenwellen erzeugbar und reflektierbar sind, wobei ein piezoelektrisches Substrat bereitgestellt wird, wonach auf dem Substrat die zumindest eine Struktur angebracht wird, wonach das Substrat mit einem Element verbunden wird.

Des Weiteren betrifft die Erfindung einen Sensor mit zumindest einer Struktur, mit der akustische Oberflächenwellen erzeugbar und reflektierbar sind, umfassend ein piezoelektrisches Substrat und zumindest ein Element, wobei die zumindest eine Struktur am Substrat angebracht ist und wobei das Substrat mit dem Element verbunden ist.

Aus dem Stand der Technik sind Sensoren bekannt, die auf Basis von akustischen Oberflächenwellen zur Temperatur- und/oder Druckbestimmung oder der Bestimmung anderer Parameter eingesetzt werden können. Derartige Sensoren sind als Surface-Acoustic-Wave-Sensoren (SAW-Sensoren) bekannt.

Bei SAW-Sensoren ist ein piezoelektrisches Substrat vorhanden, auf dem akustische Oberflächenwellen erzeugt werden, die sich an der Oberfläche des Substrates fortpflanzen. Des Weiteren sind bei SAW-Sensoren Strukturen vorgesehen, welche die sich fortpflanzenden Oberflächenwellen reflektieren. Da das piezoelektrische Substrat sich in Abhängigkeit von Temperatur und/oder Druck verformt, fällt die Reflexion der Oberflächenwellen je nach Temperatur und/oder Druck verschieden aus. Somit können durch Messung der reflektierten Oberflächenwellen Temperatur und/oder Druck oder gegebenenfalls auch andere Parameter bestimmt werden. Ist der SAW-Sensor mit einer Antenne versehen, was der Regelfall ist, kann ein Ergebnis der Reflexion und damit eine Aussage über Temperatur und/oder Druck sowie gegebenenfalls weitere Parameter von einem Messort an eine entfernte Empfangseinheit zur Auswertung übermittelt werden.

SAW-Sensoren werden entsprechend dem Vorstehenden häufig eingesetzt, wenn es gilt, an schwer zugänglichen Positionen berührungslos Prozessparameter zu bestimmen. Durch die Abstrahlung des Signals per Funk kann ein SAW-Sensor praktisch in allen Bereichen eingesetzt werden, z. B. zur Bestimmung von Temperaturen in der Verfahrensführung oder zur Bestimmung eines Druckes eines sich bewegenden Reifens. Bei der Herstellung von SAW-Sensoren werden die erforderlichen Strukturen für die Erzeugung und Reflexion häufig durch fotolithografische Prozesse auf Wafern aus dem piezoelektrischen Substrat angebracht. Danach werden die Wafer in Einzelteile geschnitten bzw. gesägt und die so erhaltenen Einzelteile auf einem Element angebracht, das die übrigen erforderlichen Strukturen wie Verbindungs- bzw. Befestigungspins und ein metallisches Gehäuse aufweist. Für die Anbringung der Wafer bzw. allgemein der Substrate mit der für Oberflächenwellen sensiblen Struktur kommt der Verbindung zwischen Substrat und Metallgehäuse bzw. Support eine entscheidende Bedeutung zu.

Damit Parameteränderungen verfolgbar sind, beispielsweise Temperatur- und/oder Druckschwankungen, muss die Dehnung des piezoelektrischen Substrates, welche auf die Umgebungsänderungen zurückzuführen ist, perfekt umgesetzt werden. Es kann daher die Anforderung formuliert werden, dass eine möglichst stabile, Dehnungen gut aufnehmende Verbindung erforderlich ist. Da SAW-Sensoren häufig bei hohen Temperaturen eingesetzt werden, soll nach Möglichkeit auch eine hohe Temperaturbeständigkeit der Verbindung gegeben sein, insbesondere bei wiederholten Lastzyklen. Vor allem ein fataler Bruch zwischen Substrat und dem Support soll möglichst vermieden werden.

Aus dem Stand der Technik sind diverse Verfahren zum Verbinden der Elemente mit einem piezoelektrischen Substrat bekannt. Standard ist eine Verbindung mittels Kleber. Kleber, beispielsweise auf Basis Polyimid oder siliconbasierte Kleber, weisen allerdings für viele Fälle nicht die erforderlich hohen Abscherkräfte auf. Insbesondere ist auch keine nachhaltige thermische Belastbarkeit gegeben. Dies kann unter anderem dazu führen, dass vor allem bei hohen Temperaturen eine erforderliche Langzeitstabilität nicht gegeben ist. Werden alternative Kleber wie beispielsweise Keramikkleber eingesetzt, führt dies zu deutlich unterschiedlichen Expansionskoeffizienten zwischen Substrat, Keramikkleber und Support, sodass unter Umständen sogar ein Bruch des Substrates bei wiederholten Lastzyklen beobachtet werden kann.

Thermisches Diffusionsbonden stellt ein alternatives Verfahren zur Verbindung des Elementes mit dem Substrat dar. Von Vorteil dabei ist, dass kein zusätzliches Verbindungsmittel zwischen dem Substrat und dem Support eingebracht wird. Ein Nachteil ist jedoch, dass hohe Drücke und Temperaturen erforderlich sind, somit relativ drastische Bedingungen, um eine dehnungsflexible Verbindung zu erreichen.

Schließlich wurde auch schon versucht, Elemente mit Substraten durch Löten zu verbinden. Wenngleich dies eine grundsätzlich geeignete Methodik darstellt, ist dabei nachteilig, dass durch ein erforderliches Flussmittel beim Löten Verschmutzungen erfolgen können, insbesondere durch Ausgasen des Flussmittels. Ein anderer Nachteil besteht in der hohen Temperatur, die für ein Löten erforderlich ist.

Aufgabe der Erfindung ist es, ein Verfahren der eingangs genannten Art anzugeben, mit welchem bei vergleichsweise schonender Vorgehensweise Support und Substrat dehnungsflexibel verbunden werden, wobei ein späterer Bruch des Substrates bei Belastung möglichst ausgeschlossen ist.

Des Weiteren ist es ein Ziel der Erfindung, einen entsprechend hergestellten Sensor anzugeben.

Die verfahrensmäßige Aufgabe der Erfindung wird dadurch gelöst, dass bei einem Verfahren der eingangs genannten Art zwischen dem Substrat und dem Element ein bei Erwärmung das Substrat und das Element (bzw. den Support) flussmittelfrei selbsttätig verbindendes und zumindest überwiegend metallisches Verbindungsmittel mit einer Schichtdicke von zumindest 10 µm vorgesehen wird.

Im Rahmen der Erfindung wurde erkannt, dass eine dauerhafte, Dehnungen zwischen Substrat und Element gut ausgleichende Verbindung erreicht werden kann, wenn das Verbindungsmittel einerseits überwiegend metallisch ist, andererseits aber auch im Gegensatz zu einem Löten auf ein Flussmittel verzichtet wird. Die so erstellte Verbindung ist darüber hinaus auch äußerst temperaturstabil, was einen Einsatz des so hergestellten Sensors bei Temperaturen von mehr als 300 °C, unter Umständen auch 500 °C oder mehr, erlaubt. Auch eine Beanspruchung des Sensors während mehrerer Temperaturzyklen ist ohne Weiteres möglich. In diesem Zusammenhang wurde auch erkannt, dass metallische Verbindungsmittel aufgrund eines geeigneten E-Moduls und einer Mindestschickdicke von 10 µm, bevorzugt zumindest 20 µm, insbesondere zumindest 30 µm, somit einer Verbundsteifigkeit, unterschiedliche Dehnungen zwischen Substrat und Element elastisch ausgleichen. Somit ist ein stabiler Verbund gegeben, der Dehnungen des Substrates erlaubt, und bei höheren Temperaturen und Temperaturzyklen im Vergleich mit Klebern gute Langzeiteigenschaften aufweist. Darüber hinaus kann bei vergleichsweise milden Temperaturen von weniger als 300 °C, insbesondere weniger als 250 °C, unter Beibehaltung einer sauberen Oberfläche und damit der Funktionstüchtigkeit des Sensors derselbe erstellt werden. Somit liegt die Einsatztemperatur des Sensors deutlich über jener Maximaltemperatur, die für die Herstellung der Verbindung erforderlich ist.

Durch die Erfindung kann insbesondere ein ausgewogener Kompromiss zwischen guter Verbindung und Dehnbarkeit des Substrates erzielt werden. Somit wird ein Zielkonflikt gelöst. Das überwiegend metallische Verbindungsmittel ermöglicht eine gute Dehnbarkeit ohne Bruch. Gleichzeitig ist aber auch eine gute Verbindung zum Support gegeben.

Besonders bevorzugt ist es, dass das zumindest eine Substrat vor der Erwärmung auf einer dem Element zugewandten Seite mit einer metallischen Schicht, vorzugsweise einer Schicht aus Gold oder Silber, versehen wird. Durch eine Metallisierung der Rückseite des Substrates, also der dem Element zugewandten Seite, mit einem Metall wie Gold oder Silber kann eine besonders innige Verbindung von Verbindungsmittel mit dem Substrat erreicht werden, was bei einem späteren Einsatz des Sensors Dehnungsmessungen im Temperaturbereich bis 700 °C ermöglicht. Möglich ist es auch, dass das Element auf einer dem Substrat zugewandten Seite mit einer weiteren metallischen Schicht versehen wird, um eine Verbindung zu optimieren.

Das Verbindungsmittel wird vorzugsweise schichtförmig mit einer Dicke von weniger als 200 µm, insbesondere weniger als 150 µm, ausgebildet. Eine Schichtdicke des Verbindungsmittels ist dann minimiert und so ausgelegt, dass die gewünschte Dehnung möglichst gut ermöglicht wird, aber auch die Qualität der Verbindung optimiert ist. Eine Schichtdicke von zumindest 20 µm, insbesondere zumindest 30 µm, erweist sich für die gewünschten Eigenschaften als zweckmäßig.

Grundsätzlich kommen beliebige metallische Verbindungsmittel für die Verbindung des Substrates mit dem Element infrage. Als besonders zweckmäßig hat es sich erwiesen, wenn das Substrat an einer der Struktur gegenüberliegenden Rückseite bzw. dem Element zugewandten Seite mit einer Paste als Verbindungsmittel überzogen wird, die überwiegend Silberpartikel mit einer Größe von 0,1 µm bis 15 µm enthält, und das Verbinden durch Temperaturerhöhung, vorzugsweise bei erhöhtem Druck, durchgeführt wird. Die Silberpartikel mit der angegebenen Größe sintern dann bereits bei Temperaturen von weniger als 250 °C zusammen und sorgen so für eine gute Verbindung zwischen Substrat und Element. Ist der Druck während der Temperaturerhöhung bzw. beim Sintern der Silberpartikel erhöht, sind besonders hohe Scherkräfte erforderlich, um das befestigte Substrat vom Element zu entfernen.

Alternativ ist es ebenfalls besonders zweckmäßig, dass vor dem Temperatureintrag zwischen dem Substrat und dem Element eine Folie eingebracht wird, die bei Erwärmung schmilzt. Hierfür eignen sich insbesondere Folien, die bei geringfügigem Temperatureintrag durch eine stark exotherme Reaktion quasi von selbst aufschmelzen. Dabei ist insbesondere wiederum auch von Vorteil, dass auf ein Flussmittel gänzlich verzichtet werden kann.

Das weitere Ziel der Erfindung wird durch einen Sensor der eingangs genannten Art erreicht, wobei zwischen dem Substrat und dem Element ein zumindest überwiegend metallisches Verbindungsmittel mit einer Schichtdicke von zumindest 10 µm vorgesehen ist, das nach Erwärmung das Substrat und das Element flussmittelfrei selbsttätig verbindet.

Ein erfindungsgemäßer Sensor zeichnet sich dadurch aus, dass eine Dehnung des Substrates aufgrund des metallischen Verbindungsmittels besonders gut ermöglicht wird und das metallische Verbindungsmittel durch einen geeigneten Expansionskoeffizienten und elastischen Spannungsausgleich zwischen Substrat und Element zu einem dauerhaft einsetzbaren Sensor führt, der auch wechselnden Temperaturbelastungen ausgezeichnet standhält, insbesondere aufgrund der Qualität der gegebenen Verbindung.

Die Qualität der Verbindung kann noch deutlich verbessert werden, wenn das zumindest eine Substrat auf einer dem Element zugewandten Seite mit einer metallischen Schicht, vorzugsweise einer Schicht aus Gold oder Silber, versehen ist. Das Element kann ebenfalls mit einer weiteren metallischen Schicht beschichtet bzw. versehen sein, um eine Anbindung im Einzelfall zu optimieren.

Um ein Optimum aus Temperaturstabilität einerseits und möglichst guter Dehnbarkeit andererseits zu finden, kann das Verbindungsmittel schichtförmig mit einer Dicke von weniger als 200 µm, insbesondere weniger als 150 µm, ausgebildet sein. Eine Schichtdicke von zumindest 20 µm, insbesondere zumindest 30 µm, ist zweckmäßig, um die gewünschten Wirkungen möglichst gut zu erreichen.

Weitere Merkmale, Vorteile und Wirkungen der Erfindung ergeben sich aus den nachfolgend dargestellten Ausführungsbeispielen. In den Zeichnungen, auf welche dabei Bezug genommen wird, zeigen:
Fig. 1 ein erstes Beispiel eines erfindungsgemäßen Sensors;
Fig. 2 ein zweites Beispiel eines erfindungsgemäßen Sensors;
Fig. 3 Messergebnisse zu Scherwerten bei einem Sensor gemäß Fig. 1;
Fig. 4 Messergebnisse zu den übertragenen Dehnungen bei einem Sensor gemäß Fig. 2.

### Beispiel 1

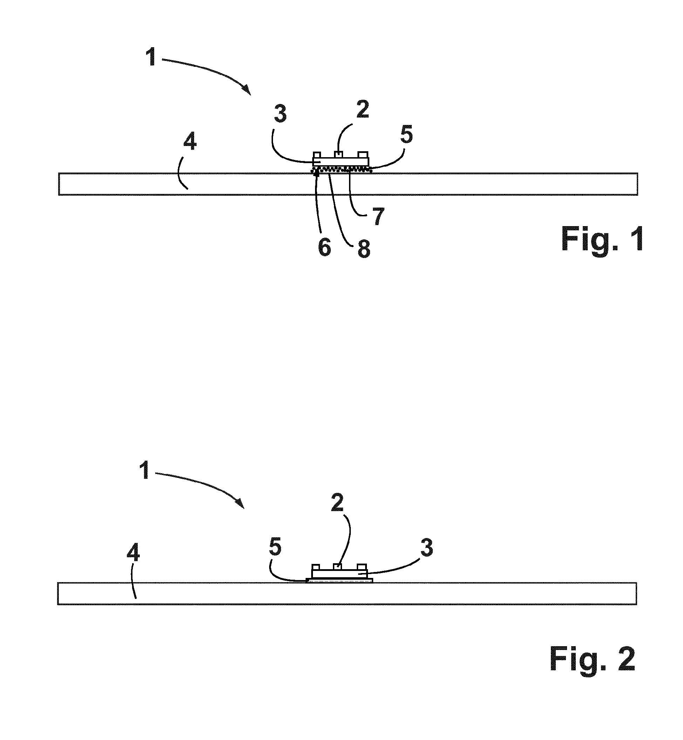

In Fig. 1 ist ein erfindungsgemäßer Sensor 1 dargestellt, der ein piezoelektrisches Substrat 3 mit einer darauf aufgebrachten Struktur 2 umfasst. Das piezoelektrische Substrat 3 kann beispielsweise aus Quarz, Langasite oder Lithiumniobat gebildet sein. Bei dem piezoelektrischen Substrat 3 handelt es sich in der Regel um ein vorzugsweise dünnes Plättchen. Das Substrat 3 ist in der Regel aus einem Wafer gebildet, der mit zumindest einer Struktur 2 versehen ist, mit der akustische Oberflächenwellen detektierbar sind. Das Substrat 3 ist auf einem Element 4, in der Regel ein metallisches Gehäuse mit weiteren Komponenten wie Befestigungspins, mittels eines überwiegend metallischen Verbindungsmittels 5 dauerhaft befestigt. Im Ausführungsbeispiel wird als metallisches Verbindungsmittel 5 eine Metallpaste eingesetzt, die Silberpartikel mit einem mittleren Teilchendurchmesser von 0,1 µm bis 15 µm aufweist. Die Silberpartikel sind zweckmäßigerweise für einen späteren Sinterprozess mit einer organischen Verbindung beschichtet. Ein Anteil der Silberpartikel in der Paste beträgt üblicherweise mehr als 70 Gewichtsprozent. Im Übrigen ist zur Verarbeitung der Paste noch ein Lösungsmittel im Ausmaß von 5 bis 20 Gewichtsprozent vorgesehen. Um den Sinterprozess zu begünstigen, können darüber hinaus Peroxide wie Dicumylperoxid und anorganische Silberverbindungen wie Silberoxid und/oder Silbercarbonat vorgesehen sein.

Bei der Herstellung des Sensors 1 wird zunächst ein piezoelektrischer Wafer auf seiner Rückseite bzw. dem Element 4 später zugewandten Seite 6 vollflächig mit einer metallischen Schicht 7 aus Gold oder Silber beschichtet. Anschließend werden auf der gegenüberliegenden Deckseite durch einen fotolithografischen Prozess Strukturen 2 geschaffen. In einem nächsten Schritt werden Substrate 3 aus dem Wafer ausgeschnitten. Eines der ausgeschnittenen Substrate 3 wird danach auf der mit der metallischen Beschichtung versehenen Rückseite zusätzlich mit der zuvor erläuterten Silberpaste versehen, die in diesem Verfahrensschritt noch pastös, also zähflüssig, aber verarbeitbar ist. Eine Dicke der aufgebrachten Schicht der Paste beträgt dabei weniger als 200 µm. Anschließend wird das so modifizierte Substrat 3 am Element 4 angeordnet, das zuvor ebenfalls mit einer weiteren metallischen Schicht 8 beschichtet worden ist. Zur Herstellung einer dauerhaften Verbindung erfolgt anschließend ein Sintern bei einer Temperatur von etwa 180 °C bis 250 °C. Das Sintern kann unter vermindertem Druck erfolgen. Bevorzugt ist es jedoch, das Sintern unter einem Druck von mehr als 1 bar in einer in Inertgasatmosphäre durchzuführen. Als Inertgas kommt beispielsweise Stickstoff zur Anwendung.

Ein Aufheizen auf eine maximale Sintertemperatur im erwähnten Temperaturbereich von 180 °C bis 250 °C erfolgt vorzugsweise in einzelnen Stufen oder gegebenenfalls auch entlang einer kontinuierlichen Rampe. Nach einer vorgegebenen Sinterzeit bei der Maximaltemperatur, die in der Regel weniger als 3 Stunden beträgt, kann das Sintern beendet und der abgekühlte Sensor 1 entnommen werden. Durch die Silberpaste ist ein metallisches Verbindungsmittel 5 zwischen Substrat 3 und Element 4 geschaffen, mit dem Dehnungen des Substrates 3 trotz dessen Befestigung am Element 4 gut realisierbar sind.

### Beispiel 2

In Fig. 2 ist ein alternatives Beispiel eines erfindungsgemäßen Sensors 1 dargestellt. Der Sensor 1 ist an sich wie jener gemäß Beispiel 1 aufgebaut. Im Unterschied zu Beispiel 1 ist das metallische Verbindungsmittel 5 jedoch aus einer dünnen, beispielsweise 40 µm bis 150 µm dicken Folie gebildet, die bei geringfügigem Temperatureintrag entzündbar ist und durch stark exotherme Reaktion ohne weitere Hilfsmittel aufschmilzt. Hierfür eignen sich beispielsweise Folien, die einen Schichtaufbau mit abwechselnd abfolgenden Schichten zweier Metalle aufweisen, insbesondere Aluminium und Nickel.

Zur Herstellung eines Sensors 1 mit einer zuvor erläuterten Schicht wird das Element 4 bereitgestellt, danach die erwähnte Folie aufgebracht und schließlich das Substrat 3 auf der Folie positioniert. Anschließend erfolgt ein geringfügiger Temperatureintrag, wodurch sich die Folie ohne Hilfsmittel wie Flussmittel entzündet, aufschmilzt und damit als metallisches Verbindungsmittel 5 Substrat 3 und Element 4 verbindet.

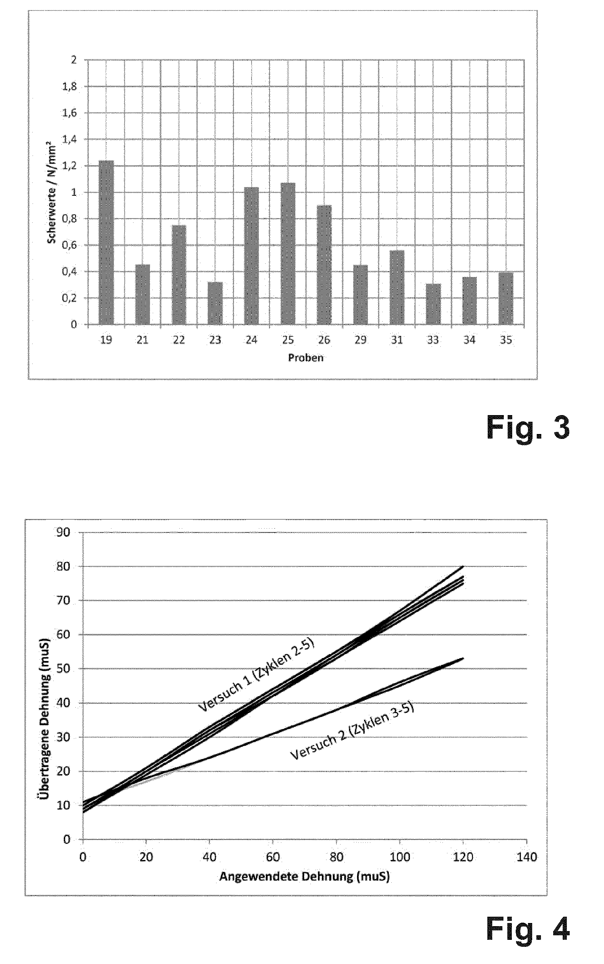

In Fig. 3 und 4 sind Messergebnisse zu Eigenschaften der Sensoren 1 gemäß den Beispielen 1 und 2 dargestellt. Fig. 3 zeigt Scherwerte für ein Substrat 3, das mit der beschriebenen Silberpaste unter Stickstoffatmosphäre am Element 4 unter Anwendung eines Temperaturprogramms aufgesintert bzw. gebonded wurde. Die gemessenen Schwerwerte zeigen, dass eine ausreichend gute Haftung des Substrates 3 am Element 4 gegeben ist. Durch ein nachfolgendes Tempern bei erhöhten Temperaturen von z. B. 600 °C können die Scherwerte noch wesentlich gesteigert werden, sodass sich die Substrate 3 nicht mehr von den Elementen 4 ablösen lassen, ohne das Bauteil zu zerstören.

In Fig. 4 sind Messergebisse gezeigt, welche für einen Sensor 1 gemäß Beispiel 2 die Übertragung der Dehnungen vom Element 4, nämlich einem Stahlblech, auf den Sensor 1 belegen. Für entsprechende Messungen sind sowohl das Element 4 als auch der Sensor 1 jeweils mit einem Dehnungssensor ausgestattet. Wie für mehrere Messungen ersichtlich ist, ergibt sich ein linearer Zusammenhang mit einer wirkungsvollen Übertragung von Dehnungen vom Element 4 auf den Sensor 1, wie dies für Anwendungen gewünscht ist.

Während mit einer Verbindung mit einer Silberpaste gemäß Beispiel 1 Bauteile für besonders hohe Temperaturen herstellbar sind, lassen sich unter Einsatz einer Folie gemäß Beispiel 2 Bauteile herstellen, bei welchen Spannungen exzellent übertragen werden.

## Patentansprüche

1. Verfahren zur Herstellung eines Sensors (1) mit zumindest einer Struktur (2), mit der akustische Oberflächenwellen erzeugbar und reflektierbar sind, wobei ein piezoelektrisches Substrat (3) bereitgestellt wird, wonach auf dem Substrat (3) die zumindest eine Struktur (2) angebracht wird, wonach das Substrat (3) mit einem Element (4) verbunden wird, **dadurch gekennzeichnet, dass** zwischen dem Substrat (3) und dem Element (4) ein bei Erwärmung das Substrat (3) und das Element (4) flussmittelfrei selbsttätig verbindendes und zumindest überwiegend metallisches Verbindungsmittel (5) mit einer Schichtdicke von zumindest 10 µm vorgesehen wird.

2. Verfahren nach Anspruch 1, **dadurch gekennzeichnet, dass** das zumindest eine Substrat (3) vor der Erwärmung auf einer dem Element (4) zugewandten Seite (6) mit einer metallischen Schicht (7), vorzugsweise einer Schicht (7) aus Gold oder Silber, versehen wird, wobei optional das Element (4) auf einer dem Substrat (3) zugewandten Seite mit einer weiteren metallischen Schicht (8) versehen wird.

3. Verfahren nach Anspruch 1 oder 2, **dadurch gekennzeichnet, dass** das Verbindungsmittel (5) mit einer Schichtdicke von weniger als 200 µm, insbesondere weniger als 150 µm, und vorzugsweise einer Schichtdicke von zumindest 20 µm, insbesondere zumindest 30 µm, ausgebildet wird.

4. Verfahren nach einem der Ansprüche 1 bis 3, **dadurch gekennzeichnet, dass** das Substrat (3) an einer der Struktur (2) gegenüberliegenden Rückseite mit einer Paste als Verbindungsmittel (5) überzogen wird, die überwiegend Silberpartikel mit einer Größe von 0,1 µm bis 15 µm enthält, und das Verbinden durch Temperaturerhöhung, vorzugsweise bei erhöhtem Druck, durchgeführt wird.

5. Verfahren nach einem der Ansprüche 1 bis 3, **dadurch gekennzeichnet, dass** vor dem Temperatureintrag zwischen dem Substrat (3) und dem Element (4) eine Folie eingebracht wird, die bei Erwärmung schmilzt.

6. Sensor (1) mit zumindest einer Struktur (2), mit der akustische Oberflächenwellen erzeugbar und reflektierbar sind, umfassend ein piezoelektrisches Substrat (3) und zumindest ein Element (4), wobei die zumindest eine Struktur (2) am Substrat (3) angebracht ist und wobei das Substrat (3) am Element (4) fixiert ist, **dadurch gekennzeichnet, dass** zwischen dem Substrat (3) und dem Element (4) ein zumindest überwiegend metallisches Verbindungsmittel (5) mit einer Schichtdicke von zumindest 10 µm vorgesehen ist, das nach Erwärmung das Substrat (3) und das Element (4) flussmittelfrei selbsttätig verbindet.

7. Sensor (1) nach Anspruch 6, **dadurch gekennzeichnet, dass** das zumindest eine Substrat (3) auf einer dem Element (4) zugewandten Seite (6) mit einer metallischen Schicht (7), vorzugsweise einer Schicht (7) aus Gold oder Silber, versehen ist, wobei optional das Element (4) auf einer dem Substrat (3) zugewandten Seite mit einer weiteren metallischen Schicht (8) versehen ist.

8. Sensor (1) nach Anspruch 6 oder 7, **dadurch gekennzeichnet, dass** das Verbindungsmittel (5) schichtförmig mit einer Dicke von weniger als 200 µm, insbesondere weniger als 150 µm, und vorzugsweise einer Schichtdicke von zumindest 20 µm, insbesondere zumindest 30 µm, ausgebildet ist.
